# DEMANDE DE BREVET EUROPEEN

(11) **EP 4 734 742 A1**
(43) Date de publication de la demande: **29.04.2026**
(21) Numéro de dépôt: 25208924.8
(22) Date de dépôt: 15.10.2025
(51) Int. Cl.: H10W 70/60

(54) **MODULE ÉLECTRONIQUE, SYSTÈME ÉLECTRONIQUE, MOULE ET PROCÉDÉ DE FABRICATION ASSOCIÉS**

(30) Priorité: 17.10.2024 FR 2411289
(71) Demandeur: Valeo eAutomotive Germany GmbH, 91056 Erlangen (DE)
(72) Inventeur: MASSOL, Laurent, 94000 CRETEIL (FR); KOPP, Gabriel, 94000 CRETEIL (FR); MORELLE, Jean-Michel, 94000 CRETEIL (FR); PIERRE, Thomas, 94000 CRETEIL (FR)
(74) Mandataire: Valeo Powertrain Systems

(57) **Abrégé**

L'invention concerne un module électronique (1) comprenant :
- un ensemble de puissance comprenant :
- une carte de puissance ; et
- au moins une piste (102) électriquement conductrice

- une carte de signal (11) montée sur la carte de puissance,
- au moins un dispositif de connexion (12) électriquement conducteur comprenant une première et une deuxième faces (121, 122) parallèles entre elles et reliées par des moyens (123) de déformation élastique, la première face étant connectée à la carte de signal, et
- un boîtier (13) enrobé sur l'ensemble de puissance, la carte de signal et au moins un dispositif de connexion, dans lequel :
- la deuxième face d'au moins un dispositif de connexion est affleurante à une surface extérieure dudit boîtier, et
- au moins un dispositif de connexion est comprimé suivant une direction perpendiculaire aux première et deuxième faces dudit dispositif de connexion.

## Description

### DOMAINE DE L'INVENTION

La présente invention concerne le domaine de l'électronique de puissance et notamment le domaine des équipements d'alimentation de moteur électrique. La présente invention concerne plus particulièrement un module électronique, un moule configuré pour surmouler ou enrober un tel module, un procédé de fabrication d'un module électronique ainsi qu'un système électronique associé.

L'invention peut trouver son application, par exemple, dans les systèmes électroniques pour onduleurs de traction, pour chargeurs embarqués, pour pompes électriques de refroidissement, par exemple, de batterie, pour pompes à chaleur, pour capteurs laser, par exemple pour conduite autonome, etc...

### ETAT DE LA TECHNIQUE

Les modules électroniques comportent généralement des contacts permettant de connecter une carte de circuit imprimé annexe comme une carte de commande d'un onduleur. Ces contacts permettent la transmission de signaux, par exemple, de commande entre le module électronique et la carte de circuit imprimé annexe.

Ces contacts sont généralement formés par des broches à emmanchement. Ce type de contact est constitué d'une broche électrique insérée en force dans un manchon (ou sleeve selon la terminologie anglosaxonne) soudé ou brasé sur le module électronique. Ces contacts sont connectés à la carte de circuit imprimé par des *" press-fit^{»}* selon la terminologie anglo-saxonne.

Un problème se pose lorsque le module électronique est soumis à des contraintes comme de fortes vibrations et/ou de fortes températures. En effet, dans ces conditions, les broches électriques ont tendance à sortir du manchon du fait des vibrations ou de la dilatation.

Un but de l'invention est notamment de corriger tout ou partie des inconvénients de l'art antérieur en proposant une solution permettant de fournir des moyens de contact électrique robustes.

### BREVE DESCRIPTION DE L'INVENTION

A cet effet, la présente invention a pour objet un module électronique comprenant :
- un ensemble de puissance comprenant :
   - une carte de puissance ; et
   - au moins une piste électriquement conductrice
   une carte de signal montée sur la carte de puissance,
   - au moins un dispositif de connexion électriquement conducteur, ledit dispositif de connexion comprenant une première face et une deuxième face parallèles entre elles et reliées par des moyens de déformation élastique, la première face étant connectée à la carte de signal,
   - un boîtier surmoulé sur l'ensemble de puissance, la carte de signal et le au moins un dispositif de connexion, dans lequel :
      - la deuxième face du au moins un dispositif de connexion est affleurante à une surface extérieure dudit boîtier, et
      - le au moins un dispositif de connexion est comprimé suivant une direction perpendiculaire la première face et à la deuxième face dudit dispositif de connexion.

Le module électronique peut également comprendre une ou plusieurs des caractéristiques ci-dessous, considérées individuellement ou selon toutes les combinaisons techniquement possibles :
- les moyens de déformation élastique d'au moins un dispositif de connexion sont agencés de façon à assurer le parallélisme de la première face et de la deuxième faces lors d'une déformation desdits moyens selon une direction perpendiculaire aux surfaces des première et deuxième faces ; et/ou
- la première face d'au moins un dispositif de connexion comprend au moins une encoche afin de faciliter sa connexion à la carte de signal ; et/ou
- au moins un dispositif de connexion comprend une bande pliée d'un matériau électriquement conducteur, ladite bande comprenant au moins un évidement au niveau d'au moins un pliage, formant notamment un angle entre 20° et 95°; et/ou
- la bande comprend plusieurs pliages, notamment entre deux et quatre; et/ou
- La bande comprend au moins un évidement au niveau de chaque pliage ; et/ou
- chaque évidement est de forme identique ; et/ou
- au moins un dispositif de connexion comprend une bande pliée d'un matériau électriquement conducteur,
- ladite bande comprenant au moins une réduction de la section de ladite bande au niveau d'au moins un pliage ; et/ou
- Le module électronique comprend au moins deux dispositifs de connexion, notamment au moins trois dispositifs de connexion, notamment au moins cinq dispositifs de connexion et/ou
- chaque dispositif de connexion étant aligné selon une direction perpendiculaire à un bord de la carte de signal ; et/ou
- l'ensemble des modules de connexion sont alignés les uns aux autres, et/ou
- au moins un dispositif de connexion a une forme prise parmi un S, un Z, un C ou un Σ ; et/ou
- la première face d'au moins un dispositif de connexion est connectée à la carte de signal par un moyen pris parmi le collage électriquement conducteur, le soudage ou le brasage ; et/ou
- au moins un dispositif de connexion est configuré pour faire transiter des signaux électriques de commande ; et/ou
- le matériau de surmoulage du boîtier est une résine époxy ; et/ou
- la au moins une piste électriquement conductrice du module électronique comprend une première partie ayant une forme plane, et une deuxième partie ayant une forme tridimensionnelle, la deuxième partie de la piste électriquement conductrice comportant une plage de connexion formant une extrémité libre de la piste, ladite plage de connexion de la deuxième partie de la piste électriquement conductrice étant affleurante à une surface extérieure du boîtier ; et/ou
- Le parallélisme au sens de la demande s'étend par une différence d'angle inférieur à 5 degrés. Il est à noter que la première face et la deuxième face avant montage peuvent présenter un angle non nul entre elles, par exemple compris entre 2 et 4 degrés, notamment égale à 3 degrés ; et/ou
- au moins un dispositif de connexion est configuré pour faire transiter des signaux électriques de commande ; et/ou

L'invention a également pour objet, un moule configuré pour enrober un boîtier sur un ensemble de puissance, une carte de signal et au moins un dispositif de connexion d'un module électronique selon l'invention,
le au moins un dispositif de connexion comprenant une première face et une deuxième face parallèles entre elles et reliées entre elles par des moyens de déformation élastique,
ledit moule étant configuré pour délimiter au moins une surface extérieure du boîtier et pour coopérer avec la deuxième face d'au moins un dispositif de connexion .

Le moule peut également comprendre une ou plusieurs des caractéristiques ci-dessous, considérées individuellement ou selon toutes les combinaisons techniquement possibles :
- le moule comprend au moins un évidement configuré pour coopérer avec la deuxième face d'au moins un dispositif de connexion, ledit au moins un évidement possédant une forme complémentaire à celle de la deuxième face d'au moins un dispositif de connexion ; et/ou
- au moins un évidement coopère avec la deuxième face d'au moins un dispositif de connexion par compression suivant une direction perpendiculaire à ladite deuxième face

L'invention a également pour objet, un procédé de fabrication d'un module électronique selon l'invention comportant les étapes suivantes :
- fournir au moins une carte de signal ;
- fournir au moins un dispositif de connexion comprenant une première face et une deuxième face parallèles entre elles et reliées entre elles par des moyens de déformation élastique, lesdits moyens de déformation élastique étant agencés de façon à assurer le parallélisme de la première face et de la deuxième face lors d'une déformation desdits moyens ;
- connecter la première face d'au moins un dispositif de connexion à au moins une carte de signal ;
- fournir au moins un moule selon l'invention,
- appliquer le moule, au contact de la deuxième face du au moins un dispositif de connexion ;
- déformer, par compression, les moyens de déformation élastique du au moins un dispositif de connexion à l'aide du moule ; l'effort de compression peut être compris entre 100N à 200N par dispositif de connexion ;
- Injecter une résine dans le moule afin d'enrober un boîtier sur l'ensemble de puissance, la au moins une carte de signal et le au moins un dispositif de connexion.

Le procédé peut également comprendre une ou plusieurs des caractéristiques ci-dessous, considérées individuellement ou selon toutes les combinaisons techniquement possibles :
- le moule comprend au moins un évidement configuré pour coopérer avec la deuxième face d'au moins un dispositif de connexion ; et/ou
- le procédé comprend en outre une étape de nettoyage de la deuxième face d'au moins un dispositif de connexion ; et/ou
- l'étape de nettoyage est réalisée par deflashing et/ou par ablation laser, notamment si l'épaisseur résiduel est importante

L'invention a également pour objet, un système électronique comprenant au moins un module électronique selon l'invention et un interconnecteur comprenant une pluralité de pattes, chaque patte étant connectée à une deuxième face des moyens de connexions.

Le module électronique du système électronique peut également comprendre un premier organe de positionnement définissant une position de référence sur ledit module électronique et l'interconnecteur comprendre un deuxième organe de positionnement configuré pour coopérer avec le premier organe de positionnement.

### BREVE DESCRIPTION DES FIGURES

L'invention sera mieux comprise à la lumière de la description suivante dans le cadre d'un module électronique, d'un système électronique, d'un moule et d'un procédé de fabrication associés, qui n'est donnée qu'à titre indicatif et qui n'a pas pour but de limiter ladite invention, accompagnée des figures ci-dessous :
[Fig.1] est une représentation schématique d'un mode de réalisation d'un module électronique selon l'invention ;
[Fig.2] est une représentation schématique d'un mode de réalisation particulier d'un module électronique selon l'invention ;
[Fig.3] est une représentation schématique d'un mode de réalisation d'un dispositif de connexion selon l'invention ;
[Fig.4] est une représentation schématique de différentes étapes du procédé de fabrication selon l'invention ;
[Fig.5] est une vue éclatée d'un mode de réalisation d'un système électronique selon l'invention.

Sur les différentes figures, les éléments analogues sont désignés par des références identiques. En outre, les différents éléments ne sont pas nécessairement représentés à l'échelle afin de présenter une vue permettant de faciliter la compréhension de l'invention.

### DESCRIPTION DETAILLEE DE L'INVENTION

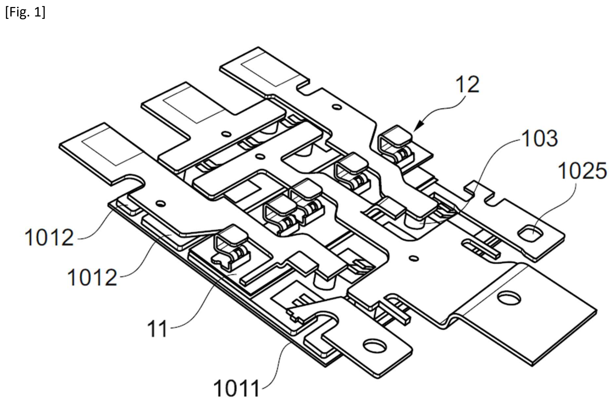

La figure 1 représente de façon schématique un mode de réalisation d'un module électronique 1 selon l'invention.

Un module électronique 1 comprend un ensemble de puissance, au moins une carte de signal 11 et au moins un dispositif de connexion 12 électriquement conducteur et un boîtier 13 enrobé sur l'ensemble de puissance, la carte de signal 11 et le au moins un dispositif de connexion 12.

Suivant un mode de réalisation, le matériau d'enrobage du boîtier 13 est une résine époxy.

L'ensemble de puissance comprend une carte de puissance 101, au moins une piste électriquement conductrice 102, distante de la carte de puissance 101, et au moins un plot de connexion 103.

L'ensemble des pistes électriquement conductrices 102 forme la grille de connexion (ou ^{«} lead frame ^{»} selon la terminologie anglo-saxonne).

La carte de puissance 101 comprend un substrat 1011 qui forme le support principal du module électronique 1.

La carte de puissance 101 comprend en outre au moins une portion de puissance 1012 déposée sur le substrat 1011. Les portions de puissances 1012 sont des bandes planes directement aménagées sur le substrat 1011, parallèles entre elles et coplanaires.

Selon le mode de réalisation illustré sur la figure 1, la carte de puissance comprend quatre portions de puissance 1012 qui sont soit au potentiel B⁻, soit au potentiel B⁺ soit au potentiel Phase.

La carte de puissance comprend également au moins un transistor de puissance . Les transistors de puissance permettant la conversion du courant continu et en un système de courant polyphasé et inversement. Il peut s'agir, par exemple, d'un transistor à effet de champ à grille isolée ou MOSFET pour Metal-Oxide-Semiconductor Field-Effect Transistor selon la terminologie anglo-saxonne.

Chaque portion de puissance 1012 est connectée électriquement à au moins une piste électriquement conductrice 102 par l'intermédiaire d'au moins un plot de connexion 103. Ainsi, chaque portion de puissance 1012 est connectée électriquement à la grille de connexion.

Les plots de connexion 103, agencés entre les portions de puissance 1012 et la grille de connexion, ont pour rôle de transmettre la puissance entre les portions de puissance 1012 et les pistes électriquement conductrices 102.

Sur la figure 1, les plots de connexion 103 ont une forme cylindrique. Cette représentation n'est nullement limitative. Les plots de connexion peuvent être de différentes formes comme des cubes, des parallélépipèdes ou tout autre forme volumique.

La carte de signal 11 est connectée électriquement à la carte de puissance 101. La carte de signal 11 est reliée aux différents transistors de puissance de la carte de puissance 101 afin d'envoyer les signaux permettant de commander les transistors de puissance.

Sur la carte de signal 11, sont connectés électriquement des dispositifs de connexion 12. Ces dispositifs de connexion 12 permettent de faire transiter des signaux électriques de commande entre la carte de signal 11 et l'extérieur du module électronique 1.

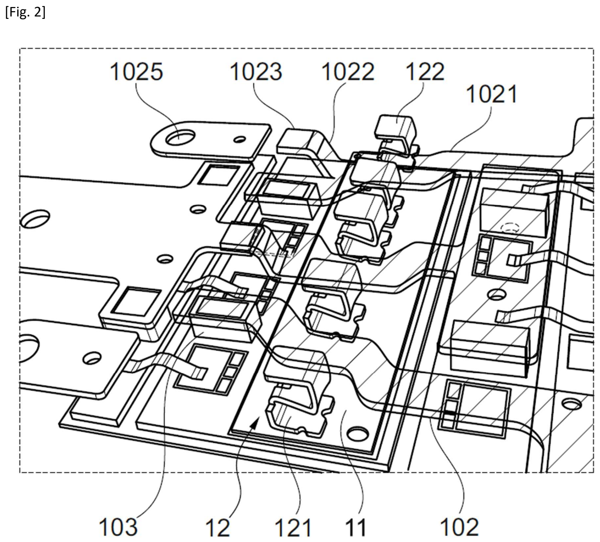

La figure 2 illustre une variante de réalisation d'un module électronique 1 selon l'invention.

Dans ce mode de réalisation, au moins une piste électriquement conductrice 102 comprend une première partie 1021 ayant une forme plane et une deuxième partie 1022 ayant une forme tridimensionnelle. La deuxième partie 1022 de la piste électriquement conductrice 102 comporte une plage de connexion 1023 formant une extrémité libre de la piste électriquement conductrice 102. La plage de connexion 1023 de la deuxième partie 1022 de la piste électriquement conductrice 102 est affleurante à une surface extérieure du boîtier 13.

De façon avantageuse, les plages de connexion 1023 permettent de prélever une valeur représentative de la tension des pistes électriquement conductrices 102 de la grille de connexion.

Suivant un mode de réalisation, au moins une plage de connexion 1023 est plane et parallèle à la carte de puissance 101.

Suivant un mode de réalisation, la deuxième partie 1022 de la piste électriquement conductrice 102 comprend une bande pliée d'un matériau électriquement conducteur.

Par la suite, on considérera comme direction longitudinale, la direction suivant la longueur du substrat 1011 du module électronique 1 et comme direction transversale, la direction suivant la largeur du substrat 1011.

Suivant un mode de réalisation, la dimension des sections transversales des première partie 1021 des pistes électriquement conductrices 102 est supérieure à une valeur prédéfinie dimensionnée afin de permettre le passage du courant, notamment pour que la densité de courant soit inférieure à 100 A rms/mm².

Selon un exemple de mode de réalisation, la première partie 1021 peut présenter une section de 3,5 mm sur 0,8 mm.

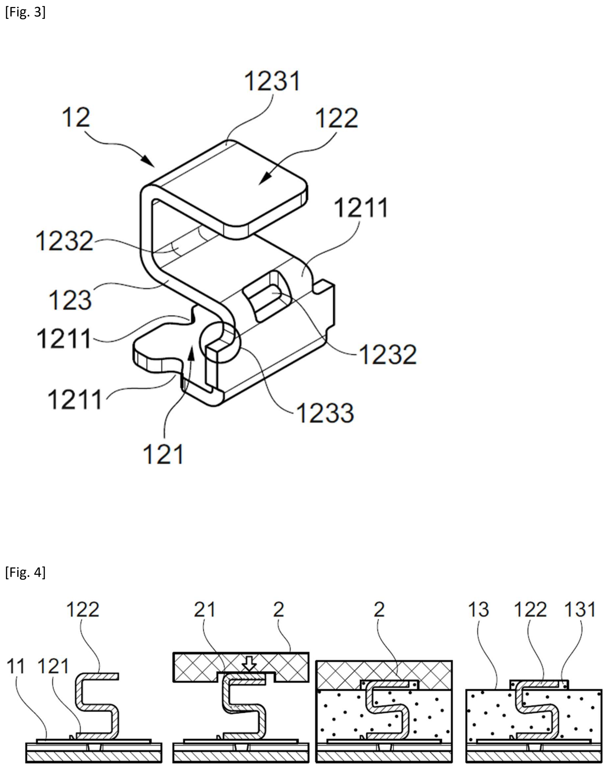

En référence à la figure 3, un dispositif de connexion 12 comprend une première face 121 et une deuxième face 122 parallèles entre elles et reliées par des moyens 123 de déformation élastique.

La première face 121 du dispositif de connexion 12 est connectée électriquement à la carte de signal 11. La connexion est réalisée par un moyen électriquement conducteur comme le soudage, par exemple laser ou ultrason, le brasage, le collage électriquement conducteur ou tout autre moyen équivalent.

Afin de faciliter sa connexion à la carte de signal, la première face 121 d'au moins un dispositif de connexion 12 peut comprendre au moins une encoche 1211. L'encoche permet de confirmer la qualité de la soudure visuellement ( AOI) &c'est pour quoi la base du clip est plus large que la tete ( surface top) pour que l'encoche soit visible vu de dessus)

La deuxième face 122 du dispositif de connexion 12 est affleurante à une surface extérieure du boîtier 13 encapsulant l'ensemble de puissance, la carte de signal 11 et le au moins un dispositif de connexion 12 du module électronique 1.

Selon un mode de réalisation, les moyens 123 de déformation élastique d'au moins un dispositif de connexion 12 sont agencés de façon à assurer le parallélisme des première et deuxième faces 121, 122 lors d'une déformation de ces moyens 123 selon une direction perpendiculaire aux surfaces des première et deuxième faces 121, 122.

Suivant un mode de réalisation, au moins un dispositif de connexion 12 comprend une bande pliée d'un matériau électriquement conducteur. La bande pliée peut comprendre au moins un évidement 1232 au niveau d'au moins un pliage 1231. De façon avantageuse, cet évidement 1232 permet de faciliter le pliage de la bande.

Suivant un mode de réalisation, la bande comprend plusieurs pliages 1231 et au moins un évidement 1232 au niveau de chaque pliage 1231. Chaque évidement 1232 peut être de forme identique ou au moins deux évidements 1232 peuvent avoir des formes différentes.

Suivant un mode de réalisation, au moins un dispositif de connexion 12 comprend une bande pliée d'un matériau électriquement conducteur, ladite bande comprenant au moins une réduction 1233 de la section de ladite bande au niveau d'au moins un pliage 1231. De façon avantageuse, cette réduction 1233 permet de faciliter le pliage de la bande.

La figure 1 présente un module électronique 1 comprenant cinq dispositifs de connexion 12. Cet exemple de configuration n'est nullement limitatif et un nombre différent de dispositifs de connexion 12 est possible.

Suivant un mode de réalisation, le module électronique 1 comprend au moins deux dispositifs de connexion 12, chaque dispositif de connexion étant aligné selon une direction perpendiculaire à un bord de la carte de signal 11.

Suivant un autre mode de réalisation, le module électronique 1 comprend au moins trois dispositifs de connexion 12, lesdits dispositifs de connexion étant alignés les uns par rapport aux autres.

Les dispositifs de connexion 12 peuvent avoir la forme d'un S, comme illustré sur la figure 3, ou tout autre forme comme un Z, un C ou un Σ. De façon avantageuse, ces formes permettent une élasticité du dispositif de connexion 12 suivant une direction perpendiculaire aux surfaces des première et deuxième faces 121, 122.

L'invention a également pour objet un moule 2 configuré pour enrober un boîtier 13 sur un ensemble de puissance, une carte de signal 11 et au moins un dispositif de connexion 12 d'un module électronique 1 tel que décrit précédemment.

Suivant un mode de réalisation, le moule 2 est configuré pour délimiter au moins une surface extérieure du boîtier du module électronique 1 et pour coopérer avec la deuxième face 122 d'au moins un dispositif de connexion 12.

Suivant un mode de réalisation, le moule 2 comprend au moins un évidement 21 configuré pour coopérer avec la deuxième face 122 d'au moins un dispositif de connexion 12. Ce au moins un évidement 21 possède une forme complémentaire à celle de la deuxième face 122 d'au moins un dispositif de connexion 12.

Suivant un mode de réalisation, la coopération de l'évidement 21 du moule 2 avec la deuxième face 122 du dispositif de connexion 12 est réalisée par compression suivant une direction perpendiculaire à la deuxième face 122.

La figure 4 représente différentes étapes d'un exemple de mise en œuvre du procédé de fabrication d'un module électronique 1 selon l'invention.

Selon un mode de mise en œuvre, le procédé de fabrication comprend les étapes suivantes :
- fournir au moins une carte de signal 11 ;
   - fournir au moins un dispositif de connexion 12 comprenant une première et une deuxième faces 121, 122 parallèles entre elles et reliées entre elles par des moyens 123 de déformation élastique. Les moyens 123 de déformation élastique sont agencés de façon à assurer le parallélisme des première et deuxième faces 121, 122 lors d'une déformation de ces moyens 123 ;
   - connecter la première face 121 d'au moins un dispositif de connexion 12 à au moins une carte de signal 11 ;
   - fournir au moins un moule 2 ;
   - appliquer le moule 2, au contact de la deuxième face 122 du au moins un dispositif de connexion 12 ;
- déformer, par compression, les moyens 123 de déformation élastique du au moins un dispositif de connexion 12 à l'aide du moule 2 ;

Suivant un mode de mise en œuvre, l'effort de compression est compris entre environ 100 N et 200 N par dispositif de connexion 12.

Au cours de cette étape, une partie du moule 2 appuie sur la deuxième face 122 d'au moins un dispositif de connexion et comprime ce dispositif 12 suivant une direction perpendiculaire à la surface de ladite deuxième face 122. Cette compression est représentée sur la figure 4 par une flèche.

De façon avantageuse, l'action du moule 2 sur au moins un dispositif de connexion 12 permet d'amener en position la deuxième face 122 de ce dispositif 12 et de fixer sa hauteur. Cela permet de garantir un alignement en hauteur des deuxièmes faces 122 des différents dispositifs de connexion 12. De même, la souplesse des dispositifs de connexion 12 permet d'éviter à ces derniers de casser lors de la compression.

Suivant un mode de mise en œuvre, la première face 121 et la deuxième face 122 ne sont pas parallèles entre elles et forment un angle compris entre environ 2° et 5° lors de l'étape de fourniture d'au moins un dispositif de connexion 12. Puis, à l'issue de l'étape de déformation par compression, le moule 2 amène la deuxième face 122 en position de sorte que la première face 121 et la deuxième face 122 soient parallèles entre elles.

Un autre avantage de l'interaction du moule 2 avec la deuxième face 122 d'au moins un dispositif de positionnement 12 est d'assurer une bonne planéité de ces deuxièmes faces 122. Cela peut trouver un intérêt, par exemple, lors de la connexion électrique de pattes de fixation sur ces deuxièmes faces 122. Cela permet d'assurer une bonne tolérance de positionnement vertical car la côte est issue du moule et que le moule interagit avec la deuxième surface 122 nette.
- Injecter une résine, par exemple une résine époxy, dans le moule 2 afin d'enrober un boîtier 13 sur la au moins une carte de signal 11 et le au moins un dispositif de connexion 12.

Pendant l'injection de la résine, au moins un dispositif de connexion 12 est comprimé suivant une direction perpendiculaire aux première et deuxième faces 121, 122 du dispositif de connexion 12. Après refroidissement et polymérisation, la résine va figer la position du au moins un dispositif de connexion 12.

De façon avantageuse, l'action du moule 2 sur les dispositifs de connexion 12 permet de limiter, voire d'éviter, le dépôt de résine sur la deuxième face 122 de ces dispositifs 12. Cela permet ainsi de limiter la reprise de la surface de ces deuxième faces 122 afin de supprimer la résine.

Suivant un mode de mise en œuvre, le procédé de fabrication comprend une étape de fourniture d'un ensemble de puissance comprenant au moins une carte de puissance 101 et une étape de connexion électrique de la carte de signal 11 avec la carte de puissance 101. Dans ce mode de mise en œuvre, l'injection de la résine dans le moule 2 permet d'enrober le boîtier 13 sur l'ensemble de puissance, la au moins une carte de signal 11 et le au moins un dispositif de connexion 12.

Suivant un mode de mise en œuvre, le procédé de fabrication comprend en outre une étape de nettoyage de la deuxième face 122 d'au moins un dispositif de connexion 12. Un but de cette étape est de supprimer le matériau d'injection du boîtier 13 qui aurait pu se déposer sur une deuxième face d'un dispositif de connexion 12 et ainsi obtenir une surface de contact propre, par exemple, apte à permettre un contact électrique avec un autre élément, par exemple, une patte de connexion.

Suivant un mode de mise en œuvre, l'étape de nettoyage de la deuxième face 122 d'au moins un dispositif de connexion 12 est réalisée par deflashing ou ablation laser.

Suivant un mode de mise en œuvre du procédé, le moule 2 utilisé pour l'injection du boîtier 13, comprend au moins un évidement 21. Cet évidement 21 est configuré pour coopérer avec la deuxième face 122 d'au moins un dispositif de connexion. Pour cela, le au moins un évidement 21 possède une forme complémentaire à celle de la deuxième face 122 d'au moins un dispositif de connexion 12.

Le au moins un évidement 21 du moule va créer, à l'issue de l'étape d'injection du boîtier 13, au moins un bossage 131 dans la surface du boîtier. La deuxième face 122 du dispositif de connexion 12 en regard de l'évidement sera affleurante à la surface extérieure du bossage 131 du boîtier 13.

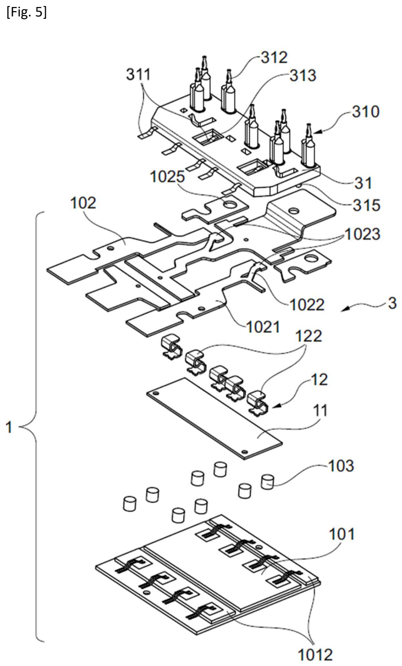

En référence à la figure 5, l'invention a également pour objet un système électronique 3 comprenant un module électronique 1 tel que décrit précédemment et un interconnecteur 31.

L'interconnecteur 31 est une pièce surmoulée permettant de rassembler différentes broches de connexion 310 sur la même pièce.

Suivant un mode de réalisation, l'interconnecteur 31 comprend une pluralité de pattes 311, chacune de ces pattes 311 étant connectée électriquement à une première extrémité des différentes broches 310. Les pattes 311 de l'interconnecteur sont destinées à être connectées électriquement à des plages de connexion du module électronique 1 comme les plages de connexion 1023 précédemment décrites et/ou les deuxièmes faces 122 des dispositifs de connexion 12. La connexion peut être réalisée par soudage, brasage, collage électriquement conducteur ou tout autre moyen équivalent.

Suivant un mode de réalisation les différentes pattes 311 de l'interconnecteur 31 sont alignées suivant une ou plusieurs rangées.

Dans l'exemple illustré sur la figure 4, les pattes 311 de l'interconnecteur sont alignées suivant deux rangées. Une première rangée est aménagée le long d'un bord extérieur de l'interconnecteur 31. Une deuxième rangée est aménagée à l'intérieur de l'interconnecteur 31. Des ouvertures 313 sont réalisées dans le surmoulage de l'interconnecteur 31 afin de rendre accessibles les pattes 311 de la deuxième rangée, par exemple, pour réaliser la connexion électrique des pattes 311 avec leurs plages de connexion du module électronique 1.

Suivant un mode de réalisation, les différentes broches 310 de l'interconnecteur 31 sont orientées perpendiculairement à la surface dudit interconnecteur 31.

Les deuxièmes extrémités 312 des broches 310 de l'interconnecteur 31 sont destinées à être connectées électriquement à au moins une carte de circuit imprimé annexe au module électronique 1, par exemple, par enfichage, par exemple, par press-fit dans des vias de la carte de circuit imprimé.

Suivant un mode de réalisation du système électronique 3, l'interconnecteur 31 est indexé par rapport au module électronique 1. Pour cela, le module électronique 1 peut comprendre au moins un premier organe de positionnement 1025 définissant une position de référence sur ledit module électronique 1. L'interconnecteur 31 comprend au moins un deuxième organe de positionnement 315 configuré pour coopérer avec le au moins un premier organe de positionnement 1025.

Dans l'exemple illustré sur la figure 4 un premier organe de positionnement 1025 est réalisé sur une piste électriquement conductrice 102 sous la forme d'un organe de forme femelle à savoir, un trou cylindrique. Un deuxième organe de positionnement 315 est réalisé dans le surmoulage de l'interconnecteur sous la forme d'un organe mâle à savoir un pion cylindrique.

## Revendications

1. Module électronique (1) comprenant :
- un ensemble de puissance comprenant :
- une carte de puissance (101) ; et
- au moins une piste (102) électriquement conductrice
- une carte de signal (11) montée sur la carte de puissance (101),
- au moins un dispositif de connexion (12) électriquement conducteur, ledit dispositif de connexion (12) comprenant une première face (121) et une deuxième face (122) parallèles entre elles et reliées par des moyens (123) de déformation élastique, la première face (121) étant connectée à la carte de signal (11), et
- un boîtier (13) enrobant l'ensemble de puissance, la carte de signal (11) et le au moins un dispositif de connexion (12), dans lequel :
- la deuxième face (122) du au moins un dispositif de connexion (12) est affleurante à une surface extérieure dudit boîtier, et
- le au moins un dispositif de connexion (12) est comprimé suivant une direction perpendiculaire aux première et deuxième faces (121, 122) dudit dispositif de connexion (12).

2. Module électronique (1) selon la revendication 1, dans lequel les moyens (123) de déformation élastique d'au moins un dispositif de connexion (12) sont agencés de façon à assurer le parallélisme de la première face (121) et de la deuxième face (122) lors d'une déformation desdits moyens (123) selon une direction perpendiculaire aux surfaces de la première face (121) et de la deuxième face (122).

3. Module électronique (1) selon la revendication 1 ou 2, dans lequel la première face (121) d'au moins un dispositif de connexion (12) comprend au moins une encoche (1211) afin de faciliter sa connexion à la carte de signal (11).

4. Module électronique (1) selon l'une des revendications précédentes, dans lequel au moins un dispositif de connexion (12) comprend une bande pliée d'un matériau électriquement conducteur, ladite bande comprenant au moins un évidement (1232) au niveau d'au moins un pliage (1231).

5. Module électronique (1) selon une des revendications précédentes, dans lequel la première face (121) d'au moins un dispositif de connexion (12) est connectée à la carte de signal (11) par un moyen pris parmi le collage électriquement conducteur, le soudage ou le brasage.

6. Module électronique (1) selon l'une des revendications précédentes, dans lequel la au moins une piste électriquement conductrice (111) comprend :
- une première partie (1111) ayant une forme plane, et
- une deuxième partie (1112) ayant une forme tridimensionnelle, la deuxième partie (1112) de la piste électriquement conductrice (111) comportant une plage de connexion (1115) formant une extrémité libre de la piste (111), et
dans lequel la plage de connexion (1115) de la deuxième partie (1112) de la piste électriquement conductrice (111) est affleurante à une surface extérieure du boîtier (13).

7. Moule (2) configuré pour enrober un boîtier (13) sur un ensemble de puissance, une carte de signal (11) et au moins un dispositif de connexion (12) d'un module électronique (1) selon l'une des revendications précédentes,
le au moins un dispositif de connexion (12) comprenant une première face (121) et une deuxième face (122) parallèles entre elles et reliées entre elles par des moyens (123) de déformation élastique,
ledit moule (2) étant configuré pour délimiter au moins une surface extérieure du boîtier (13) et pour coopérer avec la deuxième face (122) d'au moins un dispositif de connexion (12).

8. Moule (2) selon la revendication précédente, dans lequel ledit moule (2) comprend au moins un évidement (21) configuré pour coopérer avec la deuxième face (122) d'au moins un dispositif de connexion (12), ledit au moins un évidement (21) possédant une forme complémentaire à celle de la deuxième face (122) d'au moins un dispositif de connexion (12).

9. Moule (2) selon la revendication précédente, dans lequel au moins un évidement (21) coopère avec la deuxième face d'au moins un dispositif de connexion (12) par compression suivant une direction perpendiculaire à ladite deuxième face (122).

10. Procédé de fabrication d'un module électronique (1) selon une des revendications 1 à 6 comportant les étapes suivantes :
- fournir au moins une carte de signal (11) ;
- fournir au moins un dispositif de connexion (12) comprenant une première face (121) et une deuxième face (122) parallèles entre elles et reliées entre elles par des moyens (123) de déformation élastique, lesdits moyens (123) de déformation élastique étant agencés de façon à assurer le parallélisme de la première face (121) et de la deuxième face (122) lors d'une déformation desdits moyens (123) ;
- connecter la première face (121) d'au moins un dispositif de connexion (12) à au moins une carte de signal (11) ;
- fournir au moins un moule (2) selon une des revendications 7 à 9,
- appliquer le moule (2), au contact de la deuxième face (122) du au moins un dispositif de connexion (12);
- déformer, par compression, les moyens (123) de déformation élastique du au moins un dispositif de connexion (12) à l'aide du moule (2) ;
- Injecter une résine dans le moule (2) afin d'enrober un boîtier (13) sur l'ensemble de puissance, la au moins une carte de signal (11) et le au moins un dispositif de connexion (12).

11. Procédé selon la revendication 10 comprenant en outre une étape de nettoyage de la deuxième face (122) d'au moins un dispositif de connexion (12).

12. Système électronique (3) comprenant au moins un module électronique (1) selon une des revendications 1 à 6 et un interconnecteur (31) comprenant une pluralité de pattes (311), chaque patte (311) étant connectée à une deuxième face (122) des moyens de connexions (12).
